# FASCICULE DE BREVET EUROPEEN

(11) **EP 2 776 895 B1**
(45) Date de publication et mention de la délivrance du brevet: **03.03.2021**
(21) Numéro de dépôt: 12781119.8
(22) Date de dépôt: 07.11.2012
(51) Int. Cl.: G05B 15/02, E06B 9/32, G06F 3/048

(54) **PROCÉDÉ DE CONSTITUTION D'UNE STRUCTURE DE DONNÉES DE RÉFÉRENCE ET PROCÉDÉ DE COMMANDE D'UN ACTIONNEUR**
VERFAHREN ZUR ERSTELLUNG EINER REFERENZDATENSTRUKTUR UND VERFAHREN ZUR STEUERUNG EINES AKTORS
METHOD OF CONSTRUCTING A REFERENCE DATA STRUCTURE AND METHOD OF CONTROLLING AN ACTUATOR

(30) Priorité: 07.11.2011 FR 1160133; 12.04.2012 FR 1253396
(43) Date de publication de la demande: 17.09.2014
(73) Titulaire: SOMFY ACTIVITES SA, 74300 Cluses (FR)
(72) Inventeur: ROUX, Morgan, F-74190 Passy (FR); NEUMAN, Serge, F-74600 Seynod (FR); BEAUJEU, Thierry, F-74970 Marignier (FR)
(74) Mandataire: Verriest, Philippe
(86) Numéro de dépôt international: PCT/EP2012/072030
(87) Numéro de publication internationale: WO 2013/068400

(56) Documents cités:
- DE-A1-102005 032 550
- NETxAutomation Software GmbH: "NETxAutomation Software GmbH For your innovative and reliable Building Automation Solution", Product broschure, 7 mai 2010 (2010-05-07), XP002693230, Extrait de l'Internet: URL:http://www2.solar.dk/Download/netxauto mation_produktoverblik.pdf [extrait le 2013-02-27]

## Description

La présente invention concerne le domaine de l'immotique.

Plus particulièrement, la présente invention a pour objet un procédé de constitution d'une structure de données de référence comprenant au moins un paramètre de consigne d'au moins un actionneur d'un équipement d'une installation immotique et un procédé de commande d'un tel actionneur.

La présente invention a également pour objet un système comprenant un calculateur et un actionneur agencés pour mettre en œuvre de tels procédés.

Il est connu de disposer d'une installation immotique comprenant plusieurs actionneurs d'équipement électrique dont les lois de commande peuvent être déterminés par un programme interne et conditionné aux mesures effectuées par des capteurs associés a ces actionneurs.

Cependant, un tel système nécessite des ressources de calcul de la part des actionneurs et nécessite une reprogrammation sur site de chaque actionneur en cas de modification de l'environnement dans lequel est installée l'installation immotique.

Le document DE 10 2005 032 550 A1 décrit un procédé selon le préambule de la revendication 1. La présente invention a pour but de résoudre tout ou partie des inconvénients mentionnés ci-dessus, notamment par un contrôle automatique des équipements électriques faisant partie d'une installation immotique (fermetures, protections solaires, éclairage, chauffage, ventilation, alarmes, etc.).

A cet effet, la présente invention a pour objet un procédé selon la revendication 1.

Cette disposition permet de réunir dans une structure de données de référence, l'ensemble des valeurs des paramètres de consigne pouvant être employées dans une installation d'équipements électriques, et notamment d'actionneurs. Par ailleurs, Cette disposition permet de faciliter l'interprétation de la structure de données de référence.

Selon un mode de réalisation, le procédé de constitution comprend en outre une étape de détermination d'un ensemble de données de configuration de l'installation immotique, la détermination de l'au moins une valeur correspondant à l'au moins un paramètre de consigne, étant réalisée également en fonction des données de configuration de l'ensemble de données de configuration de l'installation immotique.

Cette disposition permet d'ajuster les valeurs des paramètres de consigne au plus juste par rapport à des données de configuration pouvant aller jusqu'à inclure des prévisions météorologiques.

Selon une mise en œuvre du procédé de constitution, les valeurs de paramètres de consigne pour une combinaison déterminée de valeurs des grandeurs mesurables de l'ensemble de données fonctionnelles correspondent à des valeurs de consigne pour l'au moins un actionneur.

Selon une mise en œuvre du procédé de constitution, les paramètres de consigne pour une combinaison déterminée de valeurs des grandeurs mesurables de l'ensemble de données fonctionnelles sont des paramètres d'une fonction permettant de déterminer des valeurs de consigne pour l'au moins un actionneur.

Selon une mise en œuvre du procédé de constitution, les paramètres de consigne pour une combinaison déterminée de valeurs des grandeurs mesurables de l'ensemble de données fonctionnelles sont des paramètres de sélection d'un scénario parmi une pluralité de scénarios prédéfinis permettant de déterminer des valeurs de consigne pour l'au moins un actionneur.

La présente invention a égaiement pour objet un procédé de commande selon la revendication 6.

Cette disposition permet d'éviter que les équipements électriques d'une installation, notamment les actionneurs, n'aient à calculer une consigne en fonction de valeurs renvoyées par des capteurs associés, seul un choix dans une structure de données de référence d'une valeur de paramètres de consigne permettant d'appliquer une consigne est nécessaire, ce qui économise considérablement les ressources de calcul au niveau de ces équipements électriques.

Selon une mise en œuvre du procédé de commande, la consigne de l'au moins un actionneur est déterminée à partir d'une sélection des valeurs de paramètres de consignes contenus dans le pixel sélectionné de l'image.

Selon une mise en œuvre du procédé de commande, la consigne de l'au moins un actionneur est déterminée à partir d'une fonction des valeurs de paramètres de consignes contenus dans le pixel sélectionné de l'image.

Selon une mise en œuvre du procédé de commande, la consigne de l'au moins un actionneur est déterminée à partir d'un type de scénario sélectionné parmi une pluralité de scénarios prédéfinis en fonction des valeurs de paramètres de consignes contenus dans le pixel sélectionné de l'image.

Selon une mise en œuvre du procédé de commande, la consigne de l'au moins un actionneur est déterminée en prenant en compte des valeurs de paramètres de consigne contenus dans le pixel sélectionné de l'image et la valeur mesurée par un capteur.

Selon une mise en œuvre du procédé de constitution ou du procédé de commande tels que décrits précédemment dans des modes de mise en œuvre, le positionnement d'un pixel est déterminé dans une image à deux dimensions dont la première dimension représente une échelle de valeurs correspondent à une variable de l'ensemble de variables pouvant être mesurée par un capteur associé à l'au moins un actionneur, et dont la deuxième dimension représente une échelle de valeurs correspondent à une autre variable de l'ensemble de variables pouvant être mesurées par le capteur ou un autre capteur associé à l'au moins un actionneur.

Selon une mise en œuvre de l'un ou l'autre des procédés de constitution ou de commande, la première dimension correspond à la date et la deuxième dimension correspond à une information horaire.

Selon une mise en œuvre de l'un ou l'autre des procédés de constitution ou de commande, la première dimension correspond à une information horaire dans l'année.

Selon une mise en œuvre de l'un ou l'autre des procédés de constitution ou de commande, la première dimension correspond à l'élévation et la deuxième variable correspond à l'azimuth.

Selon une mise en œuvre de l'un ou l'autre des procédés de constitution ou de commande, les composantes des pixels sont representées selon une échelle des couleurs.

Selon une mise en œuvre de l'un ou l'autre des procédés de constitution ou de commande, le procédé comporte une étape d'affichage de l'image sur un dispositif d'affichage.

Selon une mise en œuvre de l'un ou l'autre des procédés de constitution ou de commande, une pluralité de structures de données correspondant à des images est codée, les composantes des pixel d'une image parmi ladite pluralité d'image correspondant aux valeurs de paramètres de consigne destinées à au moins un actionneur parmi une pluralité d'actionneurs, le procédé comprenant en outre :
- une étape de comparaison des images appartenant à la pluralité d'image sur la base de l'évaluation d'au moins un critère de similitude ; et
- une étape de répartition des images et/ou des actionneurs par groupes en fonction de l'évaluation de l'au moins un critère de similitude.Cette disposition permet un pilotage de l'équipement électrique de l'installation par groupe d'éléments.

Selon une mise en œuvre du procédé de constitution, les étapes sont mises en œuvre par un calculateur distinct de l'au moins un actionneur.

La présente invention a également pour objet un calculateur comprenant des moyens de calcul agencés pour mettre en œuvre les étapes d'un procédé de constitution tel que décrit précédemment.

La présente invention a également pour objet un actionneur ou un ensemble comprenant un actionneur et un contrôleur associé à l'actionneur comprenant des moyens d'action agencés pour mettre en œuvre les étapes d'un procédé de commande tel que décrit précédemment.

La présente invention a également pour objet un système comprenant au moins un actionneur ou un ensemble comprenant un actionneur et un contrôleur associé 3 l'actionneur tel que décrit précédemment et au moins un calculateur tel que décrit précédemment.

Cette disposition permet de fournir un système évolutif, qui ne nécessite pas une intervention sur site pour la mise à jour des équipements électriques concernés.

De plus, ce système tient compte des conditions bioclimatiques (climat, météo), de l'emplacement et de l'orientation du bâtiment en fonction des consignes données par l'utilisateur (sécurité, présence/absence, plages horaires).

Enfin, la présente invention a pour objet un procédé de contrôle selon la revendication 22.

Selon une mise en œuvre du procédé de contrôle, la sélection d'au moins un paramètre de consigne dans la structure de données de référence est réalisée en fonction d'une combinaison de valeurs mesurées de grandeurs mesurables par des capteurs associés à l'au moins un actionneur.

Selon une mise en œuvre du procédé de contrôle, le calculateur met en œuvre une étape de détermination d'au moins une valeur correspondant à l'au moins un paramètre de consigne, pour au moins une combinaison déterminée de valeurs de grandeurs mesurables par au moins un capteur associés à l'actionneur.

La présente invention a également pour objet un produit programme d'ordinateur destiné à mettre en œuvre un procéde de constitution d'une structure de données de référence tel que décrit précédemment.

La présente invention a également pour objet un support de données comprenant les instructions dudit produit programme d'ordinateur. La présente invention a également pour objet un tel produit programme d'ordinateur installé sur un calculateur.

La présente invention a également pour objet un produit programme d'ordinateur destiné à mettre en œuvre un procéde de commande tel que décrit précédemment. La présente invention a également pour objet un support de données comprenant les instructions dudit produit programme d'ordinateur. La présente invention a également pour objet un tel produit programme d'ordinateur installé sur un actionneur ou un contrôleur associé à l'actionneur.

La présente invention a également pour objet un support de données contenant une structure de données de référence telle que décrite précédemment.

De toute façon, l'invention sera bien comprise à l'aide de la description qui suit, en référence au dessin schématique annexé représentant, à titre d'exemple non limitatif, un calculateur, un actionneur et un système mettant en œuvre les étapes des procédés selon l'invention.
La figure 1 est un schéma synoptique d'un système selon l'invention.
La figure 2 est un diagramme illustrant les étapes d'un procédé de constitution selon l'invention.
La figure 3 ets un diagramme illustrant les étapes d'un procédé de commande selon l'invention.
La figure 4 montre la génération d'une structure de données codée sous forme numérique et comprenant un ensemble de pixels définissant une image.
La figure 5 montre un premier exemple d'une représentation sous forme d'image d'une structure de données de référence.
La figure 6 montre un deuxième exemple d'une représentation sous forme d'image d'une structure de données de référence.
La figure 7 montre un troisième exemple d'une représentation sous forme d'image d'une structure de données de référence.
La figure 8 montre un quatrième exemple d'une représentation sous forme d'image d'une structure de données de référence.

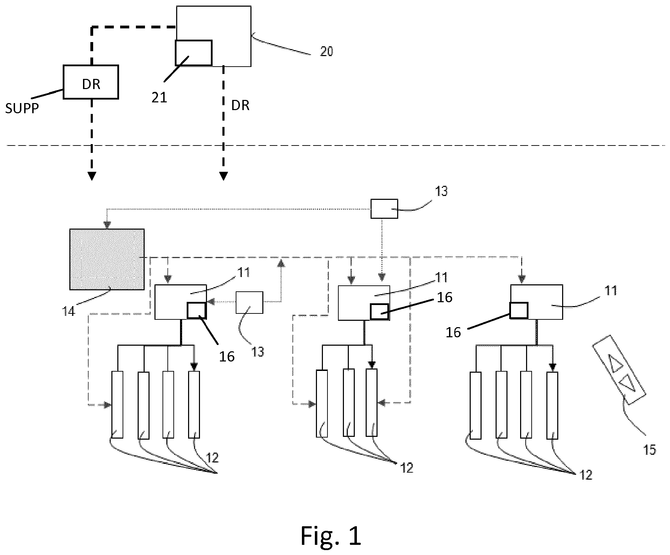

Comme illustré à la figure 1, un système 1 selon l'invention comprend au moins un actionneur 12 et au moins un calculateur 20 eux aussi selon l'invention.

Dans l'exemple présenté, le système comprend une pluralité d'actionneurs 12 faisant partie d'une installation 10 d'équipement électrique et un calculateur 20 extérieur à l'installation 10, distant ou pas et distinct de l'installation 10.

Le calculateur 20 comprend des moyens de calcul 21 dont la fonction sera décrite ultérieurement.

L'installation 10 comprend quant à elle les actionneurs 12 pour le contrôle des éléments mobiles du bâtiment (stores, volets roulants), ainsi que des équipements d'éclairage, de chauffage, de ventilation et/ou des équipements de sécurité (alarmes).

En outre, l'installation 10 comporte des contrôleurs 11 pilotant un ou plusieurs actionneurs 12, des capteurs 13 ainsi que des contrôleurs 14 d'un bâtiment ou d'une zone du bâtiment et des télécommandes locales 15 accessibles aux utilisateurs. On entend par « contrôleur associé à au moins un actionneur », le ou les contrôleurs 11 ou le ou les contrôleurs 14 d'un bâtiment ou d'une zone du bâtiment.

Les capteurs 13 renvoient vers les actionneurs 12 ou bien vers leurs contrôleurs 11 des valeurs mesurées de grandeurs mesurables VE1 telles la température, la luminosité, la vitesse du vent, la présence de pluie, ou encore la présence d'un utilisateur.

Les actionneurs 12 peuvent avoir accès aux informations les concernant en provenance des capteurs 13, ainsi qu'à des moyens de mesure du temps qui peuvent également être assimilés à des capteurs 13. Au sens de l'invention, le temps est une grandeur mesurable par des capteurs 13.

Les différents actionneurs 12 ou contrôleurs de l'actionneur11, 14 de l'installation 10 agissent sur des paramètres de consigne PAR des éléments contrôlés, par exemple la course et l'orientation pour les stores vénitiens extérieurs, la course pour les stores, l'état pour les équipements d'éclairage/ chauffage/ ventilation, etc. D'une manière connue en soi ces éléments peuvent communiquer entre eux.

Cependant, contrairement aux systèmes de l'état de la technique, où la consigne Cs est déterminée à partir de paramètres de consigne PAR calculés par chacun des actionneurs 12 au moment où ceux-ci reçoivent des informations de la part des capteurs 13 qui leur sont associés, les paramètres de consigne PAR de chacun des actionneurs 12 de l'installation 10 du système 1 selon l'invention en fonction desquels est déterminé une consigne Cs, sont calculés à l'avance par les moyens de calcul 21 du calculateur 20.

Ces paramètres de consigne PAR sont réunis dans une structure de données de référence DR qui est ensuite transférée vers les actionneurs 12, qui par l'intermédiare de leur moyens d'action 16 se servent de cette structure de données de référence DR pour déterminer une consigne Cs à appliquer à l'actionneur 12 considéré.

Ainsi, les paramètres de consignes PAR permettent d'appliquer une consigne Cs à un actionneur 12 considéré, la structure de données de référence DR pouvant être interprétée par l'intermédiaire de moyens d'action 16 de chacun des actionneurs 12.

Afin de constituer la structure de données de référence DR, le calculateur 20 met en œuvre les étapes d'un premier procédé selon l'invention, dit de constitution de ladite structure de données de référence, cette dernière comprenant au moins un paramètre de consigne PAR d'au moins un actionneur 12 d'une installation immotique 10.

Le procédé de constitution d'une structure de données de référence DR comprend une première étape S10 de détermination, selon une règle prédéfinie, d'un ensemble E1 d'au moins une combinaison CVE1 de valeurs VE1 de grandeurs mesurables par au moins un capteur 13 associé à l'actionneur 12, dit ensemble de données fonctionnelles E1.

Cette étape S10 consiste à former un ensemble E1 comprenant des combinaisons CVE1 entre les valeurs VE1 des grandeurs mesurables pouvant être théoriquement mesurées par au moins un capteur 13 associé à au moins un actionneur 12 de l'installation 10.

Une fois cet ensemble de données fonctionnelles E1 déterminé, le calculateur 20 met en œuvre une étape de détermination, pour au moins une combinaison déterminée CVE1j appartenant à l'ensemble de données fonctionnelles E1, d'au moins une valeur VPi correspondant à l'au moins un paramètre de consigne PAR.

Cette au moins une valeur VPi est déterminée en fonction de la combinaison déterminée CVE1j de l'ensemble de données fonctionnelles E1.

Ces différentes combinaison CVE1j de valeurs VE1 de l'ensemble de données fonctionnelles E1 sont donc chacune associées à des valeurs VPi correspondant à des paramètres de consigne PAR.

Le calculateur 20 dans une étape S30 génère alors la structure de données de référence DR comprenant un ensemble d'associations {CVE1j ; VPi} entre l'au moins une valeur déterminée VPi correspondant à l'au moins un paramètre de consigne PAR et la combinaison déterminée CVE1j appartenant à l'ensemble de données fonctionnelles E1.

Cette étape revient à utiliser une règle d'association prédéfinie dans le système 1 pour associer l'au moins un paramètre de consigne PAR à un ensemble de valeurs des grandeurs mesurables par les capteurs 13.

Cette règle d'association prédéfinie est connue à l'avance par le calculateur 20 et par chaque actionneur 12 ou contrôleur de l'actionneur 11, 14 concerné.

Pour chaque paramètre de consigne PAR, le calcul est donc effectué à l'avance par rapport à la mise en œuvre des paramètres calculés et par rapport aux mesures effectuées par les capteurs 13.

Ce calcul tient compte d'une série prédéterminée CVE1j de valeurs VE1 des grandeurs mesurables par les capteurs 13 ; le calcul étant fait pour les combinaisons de l'ensemble. Une combinaison de valeurs CVE1 peut correspondre, par exemple à une plage des valeurs mesurables VE1 qui engendre un changement du paramètre de consigne PAR calculé et/ou d'une valeur particulière parmi un nombre limité de possibilités, par exemple une valeur issue d'un capteur de présence/absence de personne. En particulier du moment dans la journée, et/ou de la journée dans l'année, peut être assimilée à une mesure d'une grandeur mesurable réalisée par un capteur 13.

Il est à noter que les valeurs VE1 sont mesurées effectivement par les capteurs 13 lors de la mise en œuvre des paramètres de consigne PAR en vue d'appliquer une consigne Cs pour l'actionneur 12 considéré, mais qu'à aucun moment ces valeurs VE1 ne sont envoyées au calculateur 20.

Dans un autre mode de réalisation, le calcul des paramètres de consigne PAR prend en compte un ensemble E2 de données de configuration VE2 permettant de réaliser des modèles complexes, notamment du type communément désigné par le terme « shadow management», incluant les données bioclimatiques du bâtiment, son environnement et son orientation, ainsi que d'éventuelles consignes de l'utilisateur, par exemple un ensoleillement direct inférieur à un mètre derrière une fenêtre, un mode de fonctionnement jour/nuit, un mode de fonctionnement semaine/week-end, une autorisation du mode manuel par un utilisateur, ou encore un état de fonctionnement en cas d'alarme.

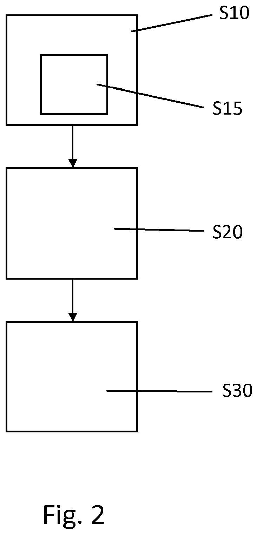

Comme illustré à la figure 2, le procédé de constitution d'une structure de données de référence DR peut comprendre en outre une étape S15 de détermination d'un ensemble E2 de données de configuration VE2 de l'installation immotique 10, la détermination de l'au moins une valeur VPi correspondant à l'au moins un paramètre de consigne PAR, étant réalisée également en fonction des données de configuration VE2 de l'ensemble E2 de données de configuration VE2 de l'installation immotique 10.

Cette étape S15 intègre par exemple une étape de modélisation du bâtiment, notamment une modélisation du bâtiment en trois dimensions et une modélisation des actionneurs 12, tels des écrans motorisés de protection solaire sur les différentes façades du bâtiment.

La modélisation peut comprendre une construction graphique ou une simple identification, par exemple une identification des ouvertures concernées par l'invention.

L'utilisation d'un logiciel spécifique dédié à la représentation virtuelle d'une forme en trois dimensions est particulièrement adaptée pour cette étape.

En particulier, les dimensions réelles et le positionnement précis des ouvertures destinées à recevoir des écrans motorisés doivent être respectées au cours de l'étape S15.

De préférence, cette modélisation prendra appui sur des plans de construction du bâtiment, voire sur une modélisation fournie par l'architecte en charge de la construction du bâtiment.

Des outils de visualisation de l'environnement, par exemple de type géoportail ou Google EarthTM peuvent également servir de support à la modélisation du bâtiment concerné.

Au cours de cette étape S15, on saisit ou on récupère donc des données relatives à la géométrie du bâtiment ainsi que des données relatives à l'orientation géographique et à la position géographique du bâtiment.

Des données concernant des prévisions météorologiques peuvent également être prises en compte au cours de la mise en œuvre de l'étape S15.

De même, les structures environnantes sont également modélisées et éventuellement insérées sur la même interface graphique que la modélisation du bâtiment automatisé.

Les structures environnantes peuvent être d'autres bâtiments, des reliefs géologiques ou naturels.

En particulier dans le cas de reliefs naturels, comme des arbres, une évolution prévisionnelle de la dimension future de ces reliefs peut également être intégrée lors de de la mise en œuvre de l'étape S15.

Au cours de cette étape S15, on saisit ou on récupère donc des données relatives à la géométrie des structures environnantes ainsi que des données relatives aux positions des structures environnantes relativement au bâtiment.

Au cours de l'étape S15, il est également possible de ne pas modéliser graphiquement le bâtiment, mais de fournir les coordonnées des différents points du maillage pour permettre de calculer la présence de soleil ou d'ombres pour chaque point du maillage du bâtiment au cours du temps.

Puis au cours de cette étape S15, on détermine, par exemple itérativement, les ombres portées sur le bâtiment. Cette notion de détermination itérative porte sur le fait de réunir par écran et par incréments de temps des données relatives à l'ensemble du bâtiment.

L'ombre portée peut être, comme expliqué précédemment, l'ombre portée par le bâtiment sur lui-même et/ou par les structures environnantes, notamment les structures modélisées au cours de l'étape S15.

De manière alternative ou complémentaire, les reflets sur le bâtiment, dus aux structures environnantes peuvent également être modélisés, les reflets étant fonction de la nature ou de la couleur des matériaux constituant les structures environnantes, notamment les façades des structures environnantes.

La détermination itérative est réalisée par une simulation de la course du soleil au cours du temps, par exemple une évaluation des trajectoires des rayons lumineux, et en tenant compte de l'impact des structures se trouvant sur les trajectoires des rayons de soleil simulés. Cette détermination itérative est réalisée pour une localisation géographique du bâtiment donnée (latitude, longitude et orientation des façades), cette information étant fournie par exemple lors de l'étape S15 de modélisation du bâtiment.

La détermination itérative peut être réalisée de manière graphique également avec représentation des ombres portées sur le bâtiment au cours du temps.

Cette détermination peut prendre en compte des données de prévisions météorologiques.

Le calcul est mis en œuvre par les moyens de calcul du calculateur 20, sur la base d'un logiciel spécifiquement mis en œuvre pour cette étape S15.

Le logiciel permet en effet de rapporter, à chaque ouverture représentée, la détermination de la présence ou non d'une ombre portée au cours du temps et d'enregistrer ces données dans un fichier de configuration.

Par exemple, le fichier peut comprendre une structure de données comprenant des identifiants d'ouverture en lignes et les différentes dates de l'année en colonnes.

Par « date », on entend un instant défini par une heure donnée d'un jour donné de l'année, par exemple 28 janvier 16h15.

En choisissant un pas de temps de 15 minutes, on obtient 24×4×365=35040 dates dans une année de 365 jours. Dans cette structure de données, on peut représenter par une valeur donnée, par exemple un « 1 », la présence d'une ombre à une date donnée au niveau d'une ouverture donnée.

On peut représenter par une valeur donnée, par exemple un « 0 », l'absence d'une ombre à une date donnée au niveau d'une ouverture donnée.

L'étape S15 de détermination d'un ensemble E2 de données de configuration VE2 de l'installation immotique 10 peut être renouvelé pour un bâtiment au cours du temps si un changement est intervenu sur le bâtiment, par exemple une modification de la structure ou un changement dans l'installation, ou sur son environnement nécessitant une mise à jour du fichier de données.

C'est par exemple le cas si un nouveau bâtiment est construit à proximité du bâtiment concerné. C'est encore le cas si la végétation s'est développée à proximité du bâtiment concerné.

La structure de données de référence DR peut être codée numériquement selon une règle de codage/décodage lors de l'étape S30 de génération de la strcuture de données de référence DR.

Cette règle de codage/décodage est également prédéfinie et connue à l'avance par le calculateur 20 et par chaque actionneur 12 ou contrôleur de l'actionneur 11, 14 concerné.

Les données de la structure de données de référence DR contenant les paramètres de consigne PAR codés selon la règle de codage/décodage et associés aux combinaisons CVE1j selon la règle d'association mentionnée précédemment.sont ensuite transférées vers les actionneurs 11, 12 de l'installation immotique 10. Le transfert peut être effectué au fur et à mesure que la structure de données est générée. Alternativement, les données peuvent être stockées dans un fichier. Ce fichier peut être transmis à l'actionneur 12 ou contrôleur de l'actionneur 11, 14 concerné ou sauvegardé sur un support de données SUPP à disposition de chacun des actionneurs 12 ou contrôleurs d'actionneurs 11, 14 de l'installation 10.

De plus, le transfert des données entre le calculateur 20 et l'installation 10 peut être effectué par le calculateur 20, ou par un autre moyen.

Selon une mise en œuvre particulière du procédé de constitution, le codage numérique est compatible avec une représentation graphique sous forme d'image I comprenant un ensemble de pixels Px.

Dans ce cas, le transfert de données peut être optimisé si cette image I est transférée sous forme compressée, par exemple sans perte.

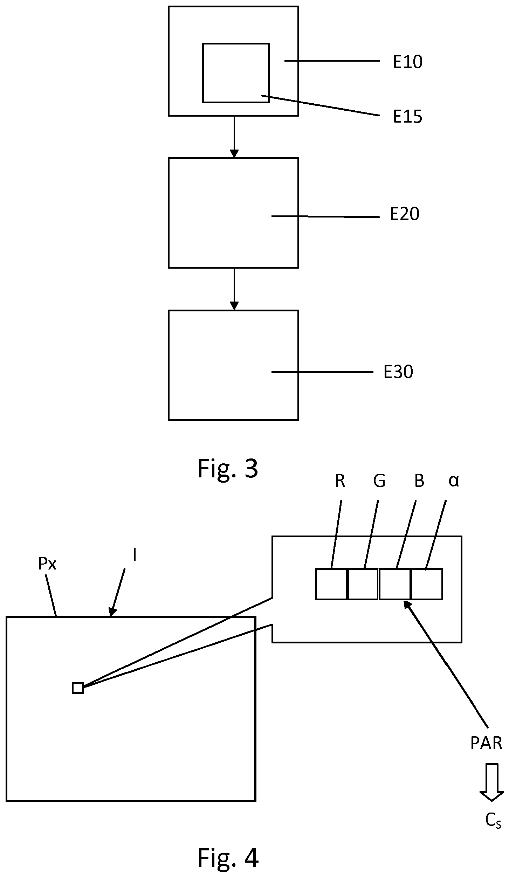

Comme illustré à la figure 4, chaque pixel Px de l'image I est défini par un positionnement et au moins une composante.

Le positionnement Pos d'un pixel Px dans l'image I est déterminé en fonction f de différentes combinaisons CVE1 de valeurs VE1 des grandeurs mesurables par l'au moins un capteur 13 associé à l'actionneur concerné.

L'au moins une composante d'un pixel Px de l'au moins une image I correspond quant à elle aux valeurs de paramètres de consigne PAR pour une combinaison CVE1 déterminée de valeurs VE1 des grandeurs mesurables de l'ensemble de données fonctionnelles E1.

Comme mentionné précédemment, les valeurs VPi des paramètres de consignes PAR permettent d'appliquer une consigne Cs à un actionneur 12 considéré.

Selon des variantes du procédé de constitution, ces valeurs de paramètres de consigne PAR correspondent soit à des valeurs de consignes Cs pour l'au moins un actionneur 12, soit à des valeurs de paramètres d'une fonction permettant de déterminer des valeurs de consigne Cs pour l'au moins un actionneur, soit à des valeurs de paramètres de sélection d'un scénario parmi une pluralité de scénarios prédéfinis et connus par l'actionneur 12 concerné et permettant de déterminer des valeurs de consigne Cs pour l'au moins un actionneur 12.

C'est ainsi que les composantes des pixels d'une représentation graphique sous forme d'image I peuvent directement renvoyer à une consigne Cs, ou bien à une autre image dont les composantes des pixels comprendrait la consigne Cs à appliquer par l'actionneur 12.

La structure de données de référence DR envoyée par le calculateur 20 ou bien stockée sur le support SUPP est utilisée par un actionneur 12 ou contrôleur d'actionneur 11, 14pour commander un équipement d'une installation immotique 10. Pour ce faire l'actionneur 12 met en œuvre les étapes d'un deuxième procédé de commande selon l'invention.

Comme illustré à la figure 3, le procédé de commande comprend une première étape E10 de détermination d'une combinaison particulière CVE1j de valeurs mesurées VE1 de grandeurs mesurables par au moins un capteur 13 associé à l'actionneur 12.

Cette étape E10 consiste à accéder aux informations issues des capteurs 13 associés à l'actionneur 12 et de déterminer une combinaison particluière CVE1 de valeurs VE1 parmi lesquelles peut figurer le temps, par exemple un moment dans la journée et la date dans l'année ou le jour de la semaine ou du week-end. Une combinaison de valeurs CVE1 peut correspondre, par exemple à une plage des valeurs mesurables VE1 qui engendre un changement du paramètre de consigne PAR calculé et/ou d'une valeur particulière parmi un nombre limité de possibilités, par exemple une valeur issue d'un capteur de présence/absence de personne.

Dans une seconde étape l'actionneur effectue un accès à une structure de données de référence DR comprenant un ensemble d'associations {CVE1j ;VPi} entre des valeurs de paramètre de consigne VPi et des valeurs prédéterminées des combinaisons CVE1j des valeurs mesurables par ledit au moins un capteur 13.

Dans une troisième étape E20, l'actionneur sélectionne au moins une valeur d de paramètre de consigne VPi, en fonction de la combinaison particulière CVE1j déterminée lors de l'étape E10 .

A cette fin, l'actionneur 12 applique la règle d'association prédéfinie avec laquelle le calculateur 20 a constitué la structure de données de référence DR.

Enfin, l'actionneur 12 applique la consigne Cs correspondant à l'au moins une valeurs VPi de paramètres de consigne PAR sélectionnée lors de l'étape E20.

L'application de la consigne Cs est effectuée suite au décodage des données selon la règle de codage/décodage avec laquelle le calculateur 20 a codé les données dans la structure de données de référence DR.

Ainsi, pour déterminer la valeur VPi des paramètres de consigne PAR, un actionneur 12 ou contrôleur de l'actionneur 11, 14' détermine d'abord une combinaison CVE1 des grandeurs mesurées effectivement par les capteurs 13, le temps faisant éventuellement partie de ces valeurs mesurées et sélectionne ensuite dans la structure de données de référence DR la valeur VPi des paramètres de consigne.

Les actionneurs 12 ou contrôleurs d'actionneur 11, 14 assurent ainsi un fonctionnement prenant en compte des modèles complexes, car les valeurs des paramètres de consigne calculés par le calculateur 20 intègrent les données de modélisation bioclimatiques, météo, etc, et assurent un fonctionnement quasi en temps réel dont le temps de réaction résulte du traitement des grandeurs mesurées par les capteurs 13 et de la lecture des valeurs VPi des paramètres de consigne PAR sur la structure de données de référence DR.

Les actionneurs 12 ou contrôleurs d'actionneur 11, 14 assurent également un fonctionnement évolutif, sans besoin de mise à jour sur le site, celle-ci étant réalisée sur le calculateur 20, notamment lors de nouveaux calculs résultant de modifications de l'environnement dans lequel est installé l'installation 10 et donc des données de configuration VE2 de l'ensemnle E2.

Il est à noter que tant que la règle de codage/décodage et la régie d'association utilisées dans le système ne changent pas, les actionneurs peuvent modifier leur comportement seulement suite à la génération d'une nouvelle structure de données de référence.

Ainsi, pour générer des nouvelles règles de fonctionnement automatiques, le calculateur 20 peut générer des nouvelles données et les transmettre aux actionneurs 12 ou contrôleurs d'actionneur 11, 14 à piloter.

L' actionneur 12 ou contrôleur de l'actionneur 11, 14 concerné, sans mise à jour matérielle ou logicielle , change de comportement par simple lecture des nouvelles données de la structure de données de référence DR.

Dans le cas où la structure de données de référence DR est codée en format numérique compatible avec une représentation sous forme d'image I, l'étape E20 de sélection d'une valeur de paramètre VPi en fonction de la combinaison particulière CVE1j de valeurs mesurées par les capteurs 13, revient à sélectionner un pixel Px dans l'image I constituant la structure de données de référence DR, comme cela est illustré à la figure 4.

Comme pour le procédé de constitution, le procédé de commande comprend des variantes dans lesquelles les valeurs des paramètres de consigne PAR correspondent soit à des valeurs de consignes Cs pour l'au moins un actionneur 12, soit à des valeurs de paramètres d'une fonction permettant de déterminer des valeurs de consigne Cs pour l'au moins un actionneur, soit à des valeurs de paramètres de sélection d'un scénario parmi une pluralité de scénarios prédéfinis permettant de déterminer des valeurs de consigne Cs pour l'au moins un actionneur 12.

Pour un codage de type « choix de scénario » parmi une pluralité de scénarios prédéfinis, l'actionneur 12 ou contrôleur de l'actionneur 11, 14 doit avoir les scénarios préprogrammés, et le calculateur 20 peut changer à distance les critères de choix du scénario à employer.

C'est ainsi que les composantes des pixels d'une représentation graphique sous forme d'image I peuvent directement renvoyer à une consigne Cs, ou bien à une autre image I dont les composantes des pixels Px comprendrait la consigne Cs à appliquer par l'actionneur 12.

Pour la représentation graphique sous forme d'image I, un format de données 4 x 8 bits est préféré car des données représentées de cette façon peuvent être représentées sous forme d'image I, en format de type « RGB-α ».

Dans ce cas, dans une représentation dans une image à deux dimensions dont la première dimension représente une échelle de valeurs correspondant à une variable de l'ensemble de variables VE1 pouvant être mesurée par un capteur 13 associé à l'au moins un actionneur 12, et dont la deuxième dimension représente une échelle de valeurs correspondant à une autre variable de l'ensemble de variables VE1 pouvant être mesurées par le capteur 13 ou un autre capteur 13 associé à l'au moins un actionneur 12.

Par exemple, dans un plan x/y, on peut représenter sur l'axe « x » les valeurs de sortie d'un premier capteur 13 (y compris le temps), sur l'axe « y » les valeurs de sortie d'un deuxième capteur 13 (y compris le temps), ainsi qu'un point de coordonnées (xp,yp) sous la forme d'un pixel (Rp, Gp, Bp, αp).

Les valeurs Rp, Gp, Bp, αp correspondant aux valeurs VPi contiennent les paramètres de consigne PAR recherchés.

Ces valeurs peuvent éventuellement comprendre des indications supplémentaires tenant compte des valeurs de sortie d'un ou plusieurs capteurs 13, mesurées lors de l'étape E10 de détermination d'une combinaison CVE1j de valeurs mesurées de grandeurs mesurables par des capteurs 13 associés à l'au moins un actionneur 12 du procédé de commande.

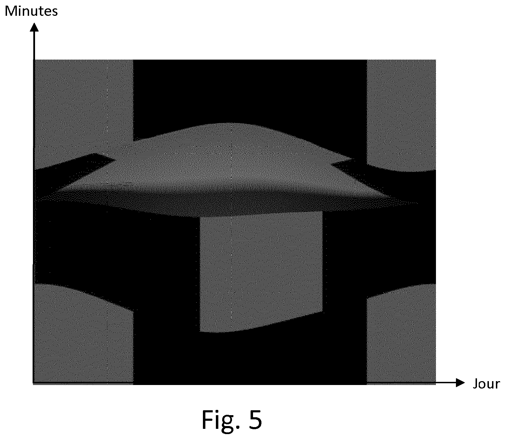

Dans l'exemple illustré à la figure 5, l'équipement électrique concerné est un équipement mobile de type store vénitien; ses paramètres de consigne PAR sont la course (entre deux valeurs prédéfinies min/max) et l'orientation des lames.

Dans une représentation graphique sous forme d'image I, l'axe « x » représente le jour dans l'année ou date, et l'axe « y » représente la minute dans la journée, ce qui constitue une information horaire.

Un pixel Px de l'image I correspondant à un point de coordonnée « x, y » et représenté en format image couleur « RGB-α » peut alors comprendre le codage suivant :
- codage « R » correspondant aux bits 31 à 24 et définissant la position en pourcentage de la course des lames dans le cas où un capteur 13 supplémentaire mesure une grandeur renvoyant une valeur selon laquelle l'utilisateur est absent,
- codage « G » correspondant aux bits 23 à 16 et définissant la position en pourcentage de l'orientation des lames dans le cas où un capteur 13 supplémentaire mesure une grandeur renvoyant une valeur selon laquelle l'utilisateur est absent,
- codage « B » correspondant aux bits 15 à 8 et définissant la position en pourcentage de la course des lames dans le cas où un capteur 13 supplémentaire mesure une grandeur renvoyant une valeur selon laquelle l'utilisateur est présent,
- codage « α » correspondant aux bits 7 à 0 et définissant la position en pourcentage de l'orientation des lames dans le cas où un capteur 13 supplémentaire mesure une grandeur renvoyant une valeur selon laquelle l'utilisateur est présent.

Ainsi, la règle d'association prédéfinie indique les données à lire, en fonction de l'état des deux capteurs 13 affectés aux deux dimensions de l'image I, en l'ocurence dans l'exemple présenté ces deux capteurs renvoient tous les deux des valeurs de temps.

La règle de codage indique quant à elle deux ensembles de paramètres de consignes, la course de l'élément mobile ; le choix entre les deux ensembles de paramètres de consignes sera fait en fonction de la sortie du capteur 13 supplémentaire informant sur la présence ou l'absence d'un utilisateur.

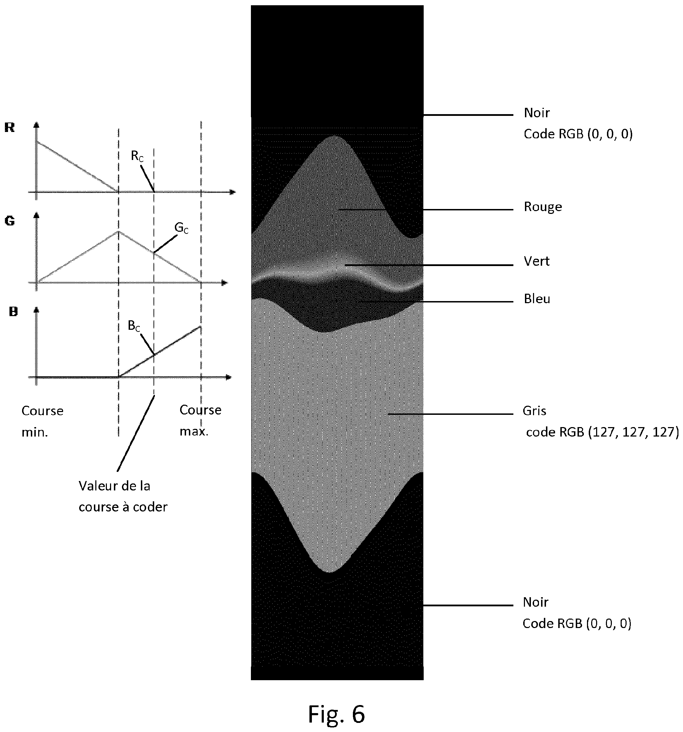

Dans un autre exemple représenté à la figure 6, l'équipement électrique concerné est un équipement mobile de type store enroulable; son paramètre de consigne PAR est la course (entre deux valeurs prédéfinies min/max).

Dans une représentation graphique sous forme d'image I, l'axe « x » représente le jour dans l'année ou date, et l'axe « y » représente la minute dans la journée, ce qui constitue une information horaire.

Un pixel Px de l'image I correspond à un point de coordonnée « x, y » et peut être représenté en format image couleur « RGB »

Le calculateur 20 détermine à l'avance si une énergie directe est présente ou pas, en fonction des données de configuartion VE2 de l'ensemble E2, notamment les données bioclimatiques, liées à l'environnement et à l'orientation du bâtiment, mais aussi de la position de la fenêtre dans le bâtiment.

Ensuite, la course du store est calculée, par exemple avec la consigne de ne pas laisser le soleil pénétrer dans le bâtiment avec plus d'un mètre.

La règle de codage change, en fonction de la présence d'une énergie directe sur la fenêtre concernée, qui peut être détectée par un capteur 13 supplémentaire, et du temps.

Si une énergie directe est susceptible d'être présente sur la fenêtre, alors la valeur de la course est représentée selon une échelle des couleurs RGB prédéterminée sinon si la variable y correspondant à des horaires de jour mais que la fenêtre est à l'ombre alors une première valeur par défaut, par exemple avec un code RGB (127, 127,127), sera utilisée pour la course et le contrôle manuel est autorisé (représentation en gris sur la figure 6).

Si dans les mêmes conditions, la variable y correspondent à des horaires de nuit, alors une deuxième valeur par défaut, par exemple avec un code RGB (0, 0 ,0) sera utilisée pour la course et le contrôle manuel n'est pas autorisé (représentation en noir sur la figure 6).

Il est à noter que comme le montre le graphique adossé à l'image de la figure 6, dans ce cas seulement une valeur (la course C) est à coder, mais trois valeurs sont utilisées (Rc, Gc, Bc). Toutes les valeurs possibles de codage ne sont pas utilisées, pour privilégier l'effet visuel sur l'œil humain et éventuellement permettre l'application des procédés connus de traitement des images.

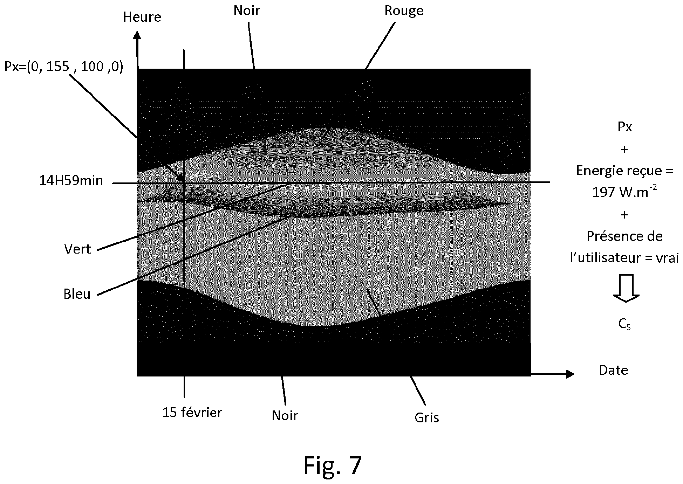

Dans un autre exemple représenté à la figure 7, l'équipement électrique concerné est un équipement mobile de type store enroulable ou volet roulant; les paramètres de consigne PAR respectifs sont les mêmes que dans les exemples précédents.

Dans une représentation graphique sous forme d'image I, l'axe « x » représente le jour dans l'année ou date, et l'axe « y» représente la minute dans la journée ce qui constitue une information horaire.

Un pixel Px de l'image I correspond a un point de coordonnée « x, y » et représente en format image couleur « RGB » l'énergie incidente directe maximale que la fenêtre concernée peut recevoir à ce moment donné.

La fenêtre a accès à un capteur 13 lui indiquant la quantité d'énergie effectivement reçue.

L'actionneur 12 ou le contrôleur 11, 14 de l'actionneur 12 peut déterminer, par exemple en utilisant une table interne, quels sont ses paramètres de consigne PAR.

Alternativement, il peut déterminer le ratio entre l'énergie reçue W et l'énergie maximale qu'il pourrait recevoir à un moment donné, et ensuite déterminer ses paramètres de consigne PAR.

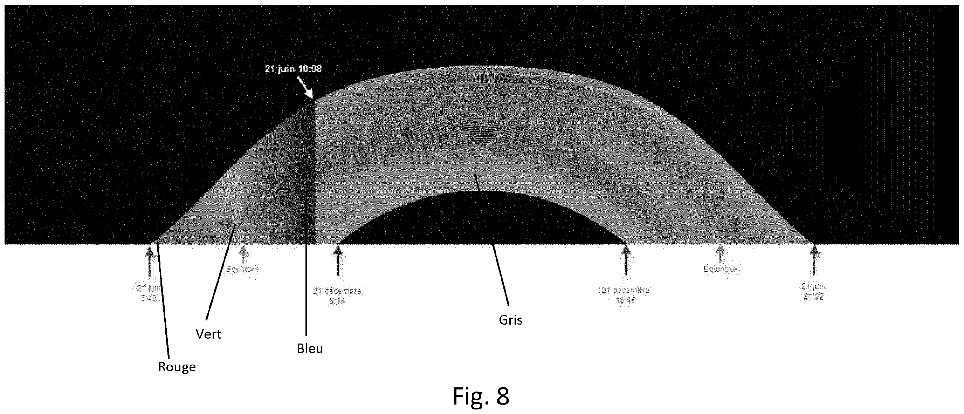

Dans un autre exemple représente à la figure 8, l'équipement électrique concerné est un équipement mobile de type store enroulable ou volet roulant; les paramètres de consigne PAR respectifs sont les mêmes que dans l'exemple précédent.

Dans une représentation graphique sous forme d'image I, l'axe « x » représente l'azimut, et l'axe « y » représente l'élévation et un point de coordonnée « x, y » représenté en format image couleur « RGB» l'énergie incidente directe maximale que la fenêtre concernée peut recevoir.

Cet exemple constitue une variante de l'exemple précédent.

Ces trois exemples utilisent une représentation codée selon une « échelle des couleurs RGB ».

Une telle représentation permet à la fois une optimisation pour la perception par l'œil, et des traitements automatiques, par traitement des images, pour plusieurs applications, notamment pour :
- une analyse et un choix des du/des type(s) de protection solaire, et
- une définition de groupes d'actionneurs 12.

En effet, selon une variante, le procédé de constitution ou de commande comprend une étape de comparaison des images I appartenant à la pluralité d'image I sur la base de l'évaluation d'au moins un critère de similitude CrS entre les images I de la pluralité d'omages I, et une étape de répartition des images I et/ou des actionneurs 12 par groupes Gr en fonction de l'évaluation de l'au moins un critère de similitude CrS.

Un groupe est donc un ensemble d'équipements électriques, par exemple de fenêtres, ayant le même comportement dans une même zone du bâtiment.

Un contrôleur 11, 14 peut gérer de manière optimisée un groupe Gr d'équipement électrique d'une même zone du bâtiment.

Ainsi, suite à la définition d'un groupe Gr ou d'une zone, le contrôleur 11, 14 peut recevoir une seule fois l'image I à utiliser pour déterminer la consigne des actionneurs 12 du groupe Gr faisant partie de la zone.

La présente invention a également pour objet un procédé de contrôle d'une installation immotique 10 comprenant au moins un actionneur 12, ledit procédé comportant une étape S30 de génération d'une structure de données de référence DR comprenant des valeurs déterminées VPi d'au moins un paramètre de consigne PAR mise en œuvre par un calculateur 20.

Cette étape peut être identique à l'étape S30 du procédé de constitution décrit précédemment, notamment dans une mise en œuvre du procédé de contrôle, le calculateur 20 met préalablement en œuvre une étape S20 de détermination d'au moins une valeur VPi correspondant à l'au moins un paramètre de consigne PAR, pour au moins une combinaison déterminée CVE1j de valeurs VE1 de grandeurs mesurables par au moins un capteur 13 associés à l'actionneur 12.

En outre, le procédé de contrôle comprend une étape de transfert de ladite structure de données de référence DR depuis le calculateur 20 vers l'au moins un actionneur12.

Ce transfert peut être réalisé par tous moyens permettant un transfert de données, les données pouvant être codées, par exemple sous forme d'image ou pas.

Enfin, le procédé de contrôle comprend une étape E30 de commande de l'au moins un actionneur 12 en appliquant une consigne Cs déterminée en fonction des valeurs de l'au moins un paramètre de consigne PAR sélectionné dans la structure de données de référence DR, mise en œuvre par l'au moins un actionneur 12.

Cette étape peut être identique à l'étape E30 du procédé de commande décrit précédemment, notamment dans une mise en œuvre du procédé de contrôle, la sélection d'au moins un paramètre de consigne PAR dans la structure de données de référence DR est réalisée en fonction d'une combinaison CVE1j de valeurs VE1 mesurées de grandeurs mesurables par des capteurs 13 associés à l'au moins un actionneur 12.

## Revendications

1. Procédé de constitution d'une structure de données de référence (DR) comprenant au moins un paramètre de consigne (PAR) d'au moins un actionneur (12) d'un équipement d'une installation immotique, comprenant :
- une étape (S10) de détermination d'un ensemble (E1) d'au moins une combinaison (CVE1) de valeurs (VE1) de grandeurs mesurables par au moins un capteur (13) associés à l'actionneur (12), dit ensemble de données fonctionnelles (E1);
- une étape (S20) de détermination, pour au moins une combinaison déterminée (CVE1j) appartenant à l'ensemble de données fonctionnelles (E1), d'au moins une valeur (VPi) correspondant à l'au moins un paramètre de consigne (PAR), en fonction de la combinaison déterminée (CVE1j) ;
- une étape (S30) de génération de la structure de données de référence (DR) comprenant un ensemble d'association ({CVE1j ; VPi}) entre l'au moins une valeur déterminée (VPi) correspondant à l'au moins un paramètre de consigne et la combinaison déterminée (CVE1j) appartenant à l'ensemble (E1) de données fonctionnelles (CVE1),
**caractérisé en ce que** l'étape (S30) de génération comprend une sous étape (S35) de codage numérique de la structure de données de référence (DR) sous forme d'image (I) comprenant un ensemble de pixels (Px), chaque pixel (Px) de l'image étant défini par un positionnement et au moins une composante,
- le positionnement (Pos) d'un pixel (Px) dans l'image (I) étant déterminé en fonction (f) des valeurs (VE1) des grandeurs mesurables dans lesdites différentes combinaisons (CVE1) de l'ensemble de données fonctionnelles (E1), et
- l'au moins une composante d'un pixel (Px) de l'au moins une image (I) correspondant aux valeurs de paramètres de consigne (PAR) pour une combinaison (CVE1) déterminée de valeurs (VE1) des grandeurs mesurables de l'ensemble de données fonctionnelles (E1).

2. Procédé selon la revendication 1, comprenant en outre une étape (S15) de de détermination d'un ensemble (E2) de données de configuration (VE2) de l'installation immotique, et dans lequel la détermination de l'au moins une valeur (VPi) correspondant à l'au moins un paramètre de consigne (PAR), est réalisée également en fonction des données de configuration (VE2) de l'ensemble (E2) de données de configuration (VE2) de l'installation immotique.

3. Procédé selon l'une des revendications précédentes, dans lequel les valeurs de paramètres de consigne (PAR) pour une combinaison (CVE1) déterminée de valeurs (VE1) des grandeurs mesurables de l'ensemble de données fonctionnelles (E1) correspondent à des valeurs de consigne (Cs) pour l'au moins un actionneur (12).

4. Procédé selon l'une des revendications précédentes, dans lequel les paramètres de consigne (PAR) pour une combinaison (CVE1) déterminée de valeurs (VE1) des grandeurs mesurables de l'ensemble de données fonctionnelles (E1) sont des paramètres d'une fonction permettant de déterminerdes valeurs de consigne (Cs) pour l'au moins un actionneur (12).

5. Procédé selon l'une des revendications précédentes, dans lequel les paramètres de consigne (PAR) pour une combinaison (CVE1) déterminée de valeurs (VE1) des grandeurs mesurables de l'ensemble de données fonctionnelles (E1) sont des paramètres de sélection d'un scénario parmi une pluralité de scénarios prédéfinis permettant de déterminer des valeurs de consigne (Cs) pour l'au moins un actionneur (12).

6. Procédé de commande d'au moins un actionneur (12) d'un équipement d'une installation immotique, le procédé étant mis en œuvre par l'actionneur (12) ou par un contrôleur (11) associé audit actionneur (12) et comprenant :
- une étape (E10) de détermination d'une combinaison (CVE1) de valeurs mesurées de grandeurs mesurables par au moins un capteur (13) associés à l'au moins un actionneur (12),
- une étape (E15) d'accès à une structure de données de référence (DR) comprenant un ensemble d'associations ({CVE1j ;VPi}) entre des valeurs de paramètre de consigne (VPi) et des valeurs prédéterminées des combinaisons (CVE1j) des valeurs mesurables par ledit au moins un capteur (13),
- une étape (E20) de sélection dans la structure de données de référence (DR) d'au moins une valeur de paramètre de consigne (VP) en fonction de ladite combinaison (CVE1) de valeurs mesurées,
- une étape (E30) de commande de l'au moins un actionneur (12) en appliquant une consigne (Cs) déterminée en fonction de l'au moins une valeur de paramètre de consigne (VP) sélectionnée dans la structure de données de référence (DR),
caractérisé en ce quel'étape (E20) de sélection consiste à sélectionner un pixel (Px) dans une structure de données numérique sous forme d'image (I) comprenant un ensemble de pixels (Px), chaque pixel étant défini par un positionnement et au moins une composante,
- le positionnement (Pos) d'un pixel (Px) dans l'image (I) étant déterminé en fonction (f) des valeurs mésurées des grandeurs mesurables par les capteurs (13) associés à l'au moins un actionneur (12) et formant différentes combinaisons (CVE1j) de valeurs (VE1) dans un ensemble de variables (E1) dit ensemble de données fonctionnelles, et
- l'au moins une composante d'un pixel (Px) de l'image (I) correspondant aux valeurs de paramètres de consigne (PAR) pour une combinaison (CVE1j) déterminée de valeurs (VE1) de l'ensemble de données fonctionnelles (E1).

7. Procédé selon la revendication 6, dans lequel la consigne (Cs) de l'au moins un actionneur (12) est déterminée à partir d'une sélection des valeurs de paramètres de consignes (PAR) contenus dans le pixel (Px) sélectionné de l'image (I).

8. Procédé selon l'une des revendications 6 à 7, dans lequel la consigne (Cs) de l'au moins un actionneur (12) est déterminée à partir d'une fonction des valeurs de paramètres de consignes (PAR) contenus dans le pixel (Px) sélectionné de l'image (I).

9. Procédé selon l'une des revendications 6 à 8, dans lequel la consigne (Cs) de l'au moins un actionneur (12) est déterminée à partir d'un type de scénario sélectionné parmi une pluralité de scénarios prédéfinis en fonction des valeurs de paramètres de consignes (PAR) contenus dans le pixel sélectionné de l'image (I).

10. Procédé selon l'une des revendications 6 à 9, dans lequel la consigne (Cs) de l'au moins un actionneur (12) est déterminée en prenant en compte des valeurs de paramètres de consignes (PAR) contenus dans le pixel (Px) sélectionné de l'image (I) et la valeur mesurée par un capteur (13).

11. Procédé selon l'une des revendications précédentes, dans lequel le positionnement (Pos) d'un pixel (Px) est déterminé dans une image (I) à deux dimensions dont la première dimension représente une échelle de valeurs correspondant à une variable de l'ensemble de variables (VE1) pouvant être mesurée par un capteur (13) associé à l'au moins un actionneur (12), et dont la deuxième dimension représente une échelle de valeurs correspondant à une autre variable de l'ensemble de variables (VE1) pouvant être mesurées par le capteur (13) ou un autre capteur (13) associé à l'au moins un actionneur (12).

12. Procédé selon la revendication 11, dans lequel la première dimension correspond à la date et la deuxième dimension correspond à une information horaire.

13. Procédé selon la revendication 11, dans lequel la première dimension correspond à une information horaire dans l'année.

14. Procédé selon la revendication 11, dans lequel la première dimension correspond à l'élévation et la deuxième variable correspond à l'azimuth.

15. Procédé selon l'une des revendications 11 à 14, dans lequel les composantes des pixels sont representées selon une échelle des couleurs.

16. Procédé selon l'une des revendications précédentes, comportant une étape d'affichage de l'image (I) sur un dispositif d'affichage.

17. Procédé selon l'une des revendications précédentes, dans lequel une pluralité de structures de données correspondant à des images (I) est codée, les composantes des pixel (Px) d'une image (I) parmi ladite pluralité d'image correspondant aux valeurs de paramètres de consigne (PAR) destinées à au moins un actionneur (12) parmi une pluralité d'actionneurs, le procédé comprenant en outre :
- une étape de comparaison des images (I) appartenant à la pluralité d'image (I) sur la base de l'évaluation d'au moins un critère de similitude (CrS) ; et
- une étape de répartition des images (I) et/ou des actionneurs (12) par groupes (Gr) en fonction de l'évaluation de l'au moins un critère de similitude (CrS).

18. Procédé selon l'une des revendications 1 à 5 ou 11 à 17 pourvu qu'elles dépendent des revendications 2 à 4 dont les étapes sont mises en œuvre par un calculateur (20) distinct de l'au moins un actionneur (12).

19. Calculateur (20) comprenant des moyens de calcul (21) agencés pour mettre en œuvre les étapes d'un procédé selon l'une des revendications 1 à 5 ou 11 à 17 pourvu qu'elles dépendent des revendications 1 à 5.

20. Actionneur (12) ou ensemble comprenant un actionneur (12) et un contrôleur (11, 14) associé à l'actionneur (12) agencés pour mettre en œuvre les étapes d'un procédé selon l'une des revendications 6 à 10 ou 11 à 17 pourvu qu'elles dépendent des revendications 6 à 10.

21. Système comprenant au moins un actionneur (12) ou un ensemble selon la revendication 20 et au moins un calculateur (20) selon la revendication 19.

22. Procédé de contrôle d'une installation immotique comprenant au moins un actionneur, ledit procédé comportant :
- une étape (S10) de détermination d'un ensemble (E1) d'au moins une combinaison (CVE1) de valeurs (VE1) de grandeurs mesurables par au moins un capteur (13) associés à l'actionneur (12), dit ensemble de données fonctionnelles (E1) ;
- une étape (S30) de génération d'une structure de données de référence (DR) comprenant des valeurs déterminées (VPi) d'au moins un paramètre de consigne (PAR) mise en œuvre par un calculateur (20),
- une étape de transfert de ladite structure de données de référence (DR) depuis le calculateur (20) vers l'au moins un actionneur (12), et
- une étape (E30) de commande de l'au moins un actionneur (12) en appliquant une consigne (Cs) déterminée en fonction des valeurs de l'au moins un paramètre de consigne (PAR) sélectionné dans la structure de données de référence (DR), mise en œuvre par l'au moins un actionneur (12) ou un contrôleur (11, 14) associé à un actionneur (12),
**caractérisé en ce que** l'étape (S30) de génération comprend une sous étape (S35) de codage numérique de la structure de données de référence (DR) sous forme d'image (I) comprenant un ensemble de pixels (Px), chaque pixel (Px) de l'image étant défini par un positionnement et au moins une composante,
- le positionnement (Pos) d'un pixel (Px) dans l'image (I) étant déterminé en fonction (f) des valeurs (VE1) des grandeurs mesurables dans lesdites différentes combinaisons (CVE1) de l'ensemble de données fonctionnelles (E1), et
- l'au moins une composante d'un pixel (Px) de l'au moins une image (I) correspondant aux valeurs de paramètres de consigne (PAR) pour une combinaison (CVE1) déterminée de valeurs (VE1) des grandeurs mesurables de l'ensemble de données fonctionnelles (E1).

23. Procédé selon la revendication 22, dans lequel la selection d'au moins un paramètre de consigne (PAR) dans la structure de données de référence (DR) est réalisée en fonction d'une combinaison (CVE1j) de valeurs (VE1) mesurées de grandeurs mesurables par des capteurs (13) associés à l'au moins un actionneur (12).

24. Procédé selon l'une des revendications 22 ou 23, dans lequel le calculateur (20) met en œuvre une étape (S20) de détermination d'au moins une valeur (VPi) correspondant à l'au moins un paramètre de consigne (PAR), pour au moins une combinaison déterminée (CVE1j) de valeurs (VE1) de grandeurs mesurables par au moins un capteur (13) associés à l'actionneur (12).

## Patentansprüche

1. Verfahren zur Herstellung einer Referenzdatenstruktur (DR), umfassend mindestens einen Vorgabeparameter (PAR) mindestens eines Aktors (12) einer Ausrüstung einer Gebäudeautomationsinstallation, umfassend:
- einen Schritt (S10) zum Bestimmen eines Satzes (E1) mindestens einer Kombination (CVE1) von Werten (VE1) durch mindestens einen Sensor (13) messbarer Größen, die dem Aktor (12) zugeordnet sind, Funktionsdatensatz (E1) genannt;
- einen Schritt (S20) zum Bestimmen für mindestens eine bestimmte Kombination (CVE1j), die dem Funktionsdatensatz (E1) angehört, mindestens eines Werts (VPi) entsprechend dem mindestens einen Vorgabeparameter (PAR) in Abhängigkeit von der bestimmten Kombination (CVEj);
- einen Schritt (S30) zum Erzeugen der Referenzdatenstruktur (DR), umfassend einen Zuordnungssatz ({CVE1j; VPi}) zwischen dem mindestens einen bestimmten Wert (VPi), der dem mindestens einen Vorgabeparameter entspricht, und der bestimmten Kombination (CVE1j) die dem Satz (E1) von Funktionsdaten (CVE1) angehört,
**dadurch gekennzeichnet, dass** der Schritt (S30) zum Erzeugen einen Teilschritt (S35) zum digitalen Codieren der Referenzdatenstruktur (DR) in Form eines Bildes (I) umfasst, das einen Bildpunktesatz (Px) umfasst, wobei jeder Bildpunkt (Px) des Bildes durch eine Positionierung und mindestens eine Komponente definiert wird,
- wobei die Positionierung (Pos) eines Bildpunktes (Px) in dem Bild (I) in Abhängigkeit (f) von den Werten (VE1) der messbaren Größen in den verschiedenen Kombinationen (CVE1) des Funktionsdatensatzes (E1) bestimmt wird, und
- die mindestens eine Komponente eines Bildpunktes (Px) des mindestens einen Bildes (I) den Vorgabeparameterwerten (PAR) für eine bestimmte Kombination (CVE1) von Werten (VE1) der messbaren Größen des Funktionsdatensatzes (E1) entspricht.

2. Verfahren nach Anspruch 1, weiter einen Schritt (S15) zum Bestimmen eines Satzes (E2) von Konfigurationsdaten (VE2) der Gebäudeautomationsinstallation umfassend, und wobei das Bestimmen des mindestens einen Werts (VPi), der dem mindestens einem Vorgabeparameter (PAR) entspricht, ebenfalls in Abhängigkeit von den Konfigurationsdaten (VE2) des Satzes (E2) von Konfigurationsdaten (VE2) der Gebäudeautomationsinstallation durchgeführt wird.

3. Verfahren nach einem der vorstehenden Ansprüche, wobei die Vorgabeparameterwerte (PAR) für eine bestimmte Kombination (CVE1) an Werten (VE1) der messbaren Größen des Funktionsdatensatzes (E1) Vorgabewerten (Cs) für den mindestens einen Aktor (12) entsprechen.

4. Verfahren nach einem der vorstehenden Ansprüche, wobei die Vorgabeparameter (PAR) für eine bestimmte Kombination (CVE1) an Werten (VE1) der messbaren Größen des Funktionsdatensatzes (E1) Parameter einer Funktion sind, die es ermöglicht, Vorgabewerte (Cs) für den mindestens einen Aktor (12) zu bestimmen.

5. Verfahren nach einem der vorstehenden Ansprüche, wobei die Vorgabeparameter (PAR) für eine bestimmte Kombination (CVE1) an Werten (VE1) der messbaren Größen des Funktionsdatensatzes (E1) Auswahlparameter eines Szenarios aus einer Vielzahl von vordefinierten Szenarien sind, die es ermöglichen, Vorgabewerte (Cs) für den mindestens einen Aktor (12) zu bestimmen.

6. Verfahren zum Steuern mindestens eines Aktors (12) einer Ausrüstung einer Gebäudeautomationsinstallation, wobei das Verfahren durch den Aktor (12) oder durch einen Controller (11) umgesetzt wird, der dem Aktor (12) zugeordnet ist, und Folgendes umfassend:
- einen Schritt (E10) zum Bestimmen eines Satzes (E1) einer Kombination (CVE1) von Messwerten durch mindestens einen Sensor (13) messbarer Größen, die dem mindestens einen Aktor (12) zugeordnet sind,
- einen Schritt (E15) für den Zugriff auf eine Referenzdatenstruktur (DR), umfassend einen Zuordnungssatz ({CVE1j; VPi}) zwischen Vorgabeparameterwerten (VPi) und vorbestimmten Werten der Kombinationen (CVE1j) der durch den mindestens einen Sensor (13) messbaren Werte,
- einen Schritt (E20) zum Auswählen in der Referenzdatenstruktur (DR) mindestens eines Vorgabeparameterwertes (VP) in Abhängigkeit von der Kombination (CVE1) von Messwerten,
- einen Schritt (E30) zum Steuern des mindestens einen Aktors (12) durch Anwenden einer bestimmten Vorgabe (Cs) in Abhängigkeit von dem mindestens einen in der Referenzdatenstruktur (DR) ausgewählten Vorgabeparameterwert (VP),
**dadurch gekennzeichnet, dass** der Schritt (E20) zum Auswählen darin besteht, einen Bildpunkt (Px) in einer digitalen Datenstruktur in Form eines Bildes (I) auszuwählen, das einen Bildpunktesatz (Px) umfasst, wobei jeder Bildpunkt durch eine Positionierung und mindestens eine Komponente definiert wird,
- wobei die Positionierung (Pos) eines Bildpunktes (Px) in dem Bild (I) in Abhängigkeit (f) von den Messwerten der durch die Sensoren (13) messbaren Größen, die dem mindestens einen Aktor (12) zugeordnet sind, und unterschiedliche Kombinationen (CVE1j) von Werten (VE1) in einem Variablensatz (E1), Funktionsdatensatz (E1) genannt, bestimmt wird, und
- die mindestens eine Komponente eines Bildpunktes (Px) des Bildes (I) den Vorgabeparameterwerten (PAR) für eine bestimmte Kombination (CVE1) von Werten (VE1) der messbaren Größen des Funktionsdatensatzes (E1) entspricht.

7. Verfahren nach Anspruch 6, wobei die Vorgabe (Cs) des mindestens einen Aktors (12) ausgehend von einer Auswahl an Vorgabeparameterwerten (PAR) bestimmt wird, die in dem ausgewählten Bildpunkt (Px) des Bildes (I) enthalten sind.

8. Verfahren nach einem der Ansprüche 6 bis 7, wobei die Vorgabe (Cs) des mindestens einen Aktors (12) ausgehend von einer Funktion der Vorgabeparameterwerte (PAR) bestimmt wird, die in dem ausgewählten Bildpunkt (Px) des Bildes (I) enthalten sind.

9. Verfahren nach einem der Ansprüche 6 bis 8, wobei die Vorgabe (Cs) des mindestens einen Aktors (12) ausgehend von einem Typ eines ausgewählten Szenarios aus einer Vielzahl von vordefinierten Szenarien in Abhängigkeit von den Vorgabeparameterwerten (PAR) bestimmt wird, die in dem ausgewählten Bildpunkt des Bildes (I) enthalten sind.

10. Verfahren nach einem der Ansprüche 6 bis 9, wobei die Vorgabe (Cs) des mindestens einen Aktors (12) bestimmt wird, indem Vorgabeparameterwerte (PAR), die in dem ausgewählten Bildpunkt (Px) des Bildes (I) enthalten sind, und der durch einen Sensor (13) gemessene Wert berücksichtigt werden.

11. Verfahren nach einem der vorstehenden Ansprüche, wobei die Positionierung (Pos) eines Bildpunktes (Px) in einem Bild (I) in zwei Dimensionen bestimmt wird, deren erste Dimension eine Werteskala repräsentiert, die einer Variablen des Variablensatzes (VE1) entspricht, die durch einen Sensor (13) gemessen werden können, der dem mindestens einen Aktor (12) zugeordnet ist, und deren zweite Dimension eine Werteskala repräsentiert, die einer anderen Variablen des Variablensatzes (VE1) entspricht, die durch den Sensor (13) oder einen anderen Sensor (13) gemessen werden können, der dem mindestens einen Aktor (12) zugeordnet ist.

12. Verfahren nach Anspruch 11, wobei die erste Dimension dem Datum entspricht und die zweite Dimension einer Uhrzeitinformation entspricht.

13. Verfahren nach Anspruch 11, wobei die erste Dimension einer Uhrzeitinformation im Jahr entspricht.

14. Verfahren nach Anspruch 11, wobei die erste Dimension der Erhebung entspricht, und die zweite Dimension dem Azimut entspricht.

15. Verfahren nach einem der Ansprüche 11 bis 14, wobei die Komponenten der Bildpunkte entsprechend einer Farbskala repräsentiert sind.

16. Verfahren nach einem der vorstehenden Ansprüche, welches einen Schritt zum Anzeigen des Bildes (I) auf einer Anzeigevorrichtung beinhaltet.

17. Verfahren nach einem der vorstehenden Ansprüche, wobei eine Vielzahl von Datenstrukturen, die Bildern (I) entsprechen, codiert ist, wobei die Komponenten der Bildpunkte (Px) eines Bildes (I) aus der Bildvielzahl den Vorgabeparameterwerten (PAR) entsprechen, die für mindestens einen Aktor (12) aus einer Vielzahl von Aktoren bestimmt sind, wobei das Verfahren weiter Folgendes umfasst:
- einen Schritt zum Vergleichen, der Bilder (I), die der Bildvielzahl (I) angehören, auf der Basis der Bewertung mindestens eines Ähnlichkeitskriteriums (CrS); und
- einen Schritt zum Aufteilen der Bilder (I) und/ oder der Aktoren (12) in Gruppen (Gr) in Abhängigkeit von der Bewertung des mindestens einen Ähnlichkeitskriteriums (CrS).

18. Verfahren nach einem der Ansprüche 1 bis 5 oder 11 bis 17, vorausgesetzt, dass sie von den Ansprüchen 2 bis 4 abhängig sind, deren Schritte durch einen Rechner (20) umgesetzt werden, der sich von dem mindestens einen Aktor (12) unterscheidet.

19. Rechner (20), Rechenmittel (21) umfassend, die angeordnet sind, um die Schritte eines Verfahrens nach einem der Ansprüche 1 bis 5 oder 11 bis 17, vorausgesetzt, dass sie von den Ansprüchen 1 bis 5 abhängig sind, umzusetzen.

20. Aktor (12) oder Satz, umfassend einen Aktor (12) und einen Controller (11, 14), der dem Aktor (12) zugeordnet ist, die angeordnet sind, um die Schritte eines Verfahrens nach einem der Ansprüche 6 bis 10 oder 11 bis 17, vorausgesetzt, dass sie von den Ansprüchen 6 bis 10 abhängig sind, umzusetzen.

21. System, umfassend mindestens einen Aktor (12) oder einen Satz nach Anspruch 20 und mindestens einen Rechner (20) nach Anspruch 19.

22. Verfahren zum Kontrollieren einer Gebäudeautomationsinstallation, umfassend mindestens einen Aktor, wobei das Verfahren umfasst:
- einen Schritt (S10) zum Bestimmen eines Satzes (E1) mindestens einer Kombination (CVE1) von Werten (VE1) durch mindestens einen Sensor (13) messbarer Größen, die dem Aktor (12) zugeordnet sind, Funktionsdatensatz (E1) genannt;
- einen Schritt (S30) zum Erzeugen der Referenzdatenstruktur (DR), bestimmte Werte (VPi) mindestens eines Vorgabeparameters (PAR) umfassend, die durch einen Rechner (20) umgesetzt wird,
- einen Transferschritt der Referenzdatenstruktur (DR) von dem Rechner (20) zu mindestens einem Aktor (12), und
- einen Schritt (S30) zum Steuern des mindestens einen Aktors (12) durch Anwenden einer bestimmten Vorgabe (Cs) in Abhängigkeit von den Werten des mindestens einen Vorgabeparameters (PAR), der in der Referenzdatenstruktur (DR) ausgewählt wird, die durch den mindestens einen Aktor (12) oder einen Controller (11, 14), der dem Aktor (12) zugeordnet ist, umgesetzt wird, **dadurch gekennzeichnet, dass** der Schritt (S30) zum Erzeugen einen Teilschritt (S35) zum digitalen Codieren der Referenzdatenstruktur (DR) in Form eines Bildes (I) umfasst, das einen Bildpunktesatz (Px) umfasst, wobei jeder Bildpunkt (Px) des Bildes durch eine Positionierung und mindestens eine Komponente definiert wird,
- wobei die Positionierung (Pos) eines Bildpunktes (Px) in dem Bild (I) in Abhängigkeit (f) von den Werten (VE1) der messbaren Größen in den verschiedenen Kombinationen (VE1) des Funktionsdatensatzes (E1) bestimmt wird, und
- die mindestens eine Komponente eines Bildpunktes (Px) des mindestens einen Bildes (I) den Vorgabeparameterwerten (PAR) für eine bestimmte Kombination (CVE1) von Werten (VE1) der messbaren Größen des Funktionsdatensatzes (E1) entspricht.

23. Verfahren nach Anspruch 22, wobei die Auswahl mindestens eines Vorgabeparameters (PAR) in der Referenzdatenstruktur (DR) in Abhängigkeit von einer Kombination (CVE1j) von Messwerten (VE1) durch Sensoren (13) messbarer Größen, die dem mindestens einen Aktor (12) zugeordnet sind, durchgeführt wird.

24. Verfahren nach einem der Ansprüche 22 oder 23, wobei der Rechner (20) einen Schritt (S20) zum Bestimmen mindestens eines Wertes (VPi), der dem mindestens einen Vorgabeparameter (PAR) entspricht, für mindestens eine bestimmte Kombination (CVE1j) von Werten (VE1) durch mindestens einen Sensor (13) messbarer Größen umsetzt, die dem Aktor (12) zugeordnet sind.

## Claims

1. A method for constituting a reference data structure (DR) comprising at least one setpoint parameter (PAR) of at least one actuator (12) of an equipment of a building automation installation, comprising:
- a step (S10) of determining a set (E1) of at least one combination (CVE1) of values (VE1) of quantities measurable by at least one sensor (13) associated to the actuator (12), called set of functional data (E1);
- a step (S20) of determining, for at least one determined combination (CVE1j) belonging to the set of functional data (E1), at least one value (VPi) corresponding to the at least one setpoint parameter (PAR), as a function of the determined combination (CVE1j);
- a step (S30) of generating the reference data structure (DR) comprising a set of association ({CVE1j; VPi}) between the at least one determined value (VPi) corresponding to the at least one setpoint parameter and the determined combination (CVE1j) belonging to the set (E1) of functional data (CVE1),
**characterized in that** the generation step (S30) comprises a sub-step (S35) of digitally encoding the reference data structure (DR) in the form of an image (I) comprising a set of pixels (Px), each pixel (Px) of the image being defined by a positioning and at least one component,
- the positioning (Pos) of a pixel (Px) in the image (I) being determined as a function (f) of the values (VE1) of the measurable quantities in said different combinations (CVE1) of the set of functional data (E1), and
- the at least one component of a pixel (Px) of the at least one image (I) corresponding to the setpoint parameter values (PAR) for a determined combination (CVE1) of values (VE1) of the measurable quantities of the set of functional data (E1).

2. The method according to claim 1, further comprising a step (S15) of determining a set (E2) of configuration data (VE2) of the building automation installation, and wherein the determination of the at least one value (VPi) corresponding to the at least one setpoint parameter (PAR), is also carried out as a function of the configuration data (VE2) of the set (E2) of configuration data (VE2) of the building automation installation.

3. The method according to any of the preceding claims, wherein the setpoint parameter values (PAR) for a determined combination (CVE1) of values (VE1) of the measurable quantities of the set of functional data (E1) correspond to setpoint values (Cs) for the at least one actuator (12).

4. The method according to any of the preceding claims, wherein the setpoint parameters (PAR) for a determined combination (CVE1) of values (VE1) of the measurable quantities of the set of functional data (E1) are parameters of a function allowing determining setpoint values (Cs) for the at least one actuator (12).

5. The method according to any of the preceding claims, wherein the setpoint parameters (PAR) for a determined combination (CVE1) of values (VE1) of the measurable quantities of the set of functional data (E1) are parameters for selecting a scenario among a plurality of predefined scenarios allowing determining setpoint values (Cs) for the at least one actuator (12).

6. A method for controlling the at least one actuator (12) of an equipment of a building automation installation, the method being implemented by the actuator (12) or by a controller (11) associated to said actuator (12) and comprising:
- a step (E10) of determining a combination (CVE1) of measured values of quantities measurable by at least one sensor (13) associated to the at least one actuator (12),
- a step (E15) of accessing a reference data structure (DR) comprising a set of associations ({CVE1j; VPi}) between setpoint parameter values (VPi) and predetermined values of the combinations (CVE1j) of the values measurable by said at least one sensor (13),
- a step (E20) of selecting in the reference data structure (DR) at least one setpoint parameter value (VP) as a function of said combination (CVE1) of measured values,
- a step (E30) of controlling the at least one actuator (12) by applying a setpoint (Cs) determined as a function of the at least one setpoint parameter value (VP) selected in the reference data structure (DR),
**characterized in that** the selection step (E20) consists in selecting a pixel (Px) in a digital data structure in the form of an image (I) comprising a set of pixels (Px), each pixel being defined by a positioning and at least one component,
- the positioning (Pos) of a pixel (Px) in the image (I) being determined as a function (f) of the measured values of the quantities measurable by the sensors (13) associated to the at least one actuator (12) and forming different combinations (CVE1j) of values (VE1) in a set of variables (E1) called set of functional data, and
- the at least one component of a pixel (Px) of the image (I) corresponding to the setpoint parameter values (PAR) for a determined combination (CVE1j) of values (VE1) of the set of functional data (E1).

7. The method according to claim 6, wherein the setpoint (Cs) of the at least one actuator (12) is determined from a selection of the setpoint parameter values (PAR) contained in the selected pixel (Px) of the image (I).

8. The method according to any of claims 6 to 7, wherein the setpoint (Cs) of the at least one actuator (12) is determined from a function of the setpoint parameter values (PAR) contained in the selected pixel (Px) of the image (I).

9. The method according to any of claims 6 to 8, wherein the setpoint (Cs) of the at least one actuator (12) is determined from a type of scenario selected among a plurality of predefined scenarios as a function of the setpoint parameter values (PAR) contained in the selected pixel of the image (I).

10. The method according to any of claims 6 to 9, wherein the setpoint (Cs) of the at least one actuator (12) is determined by taking into account setpoint parameter values (PAR) contained in the selected pixel (Px) of the image (I) and the value measured by a sensor (13).

11. The method according to any of the preceding claims, wherein the positioning (Pos) of a pixel (Px) is determined in a two-dimensional image (I) whose first dimension represents a scale of values corresponding to a variable of the set of variables (VE1) which can be measured by a sensor (13) associated to the at least one actuator (12), and whose second dimension represents a scale of values corresponding to another variable of the set of variables (VE1) which can be measured by the sensor (13) or another sensor (13) associated to the at least one actuator (12).

12. The method according to claim 11, wherein the first dimension corresponds to the date and the second dimension corresponds to a time information.

13. The method according to claim 11, wherein the first dimension corresponds to a time information in the year.

14. The method according to claim 11, wherein the first dimension corresponds to the elevation and the second variable corresponds to the azimuth.

15. The method according to any of claims 11 to 14, wherein the components of the pixels are represented according to a color scale.

16. The method according to any of the preceding claims, including a step of displaying the image (I) on a display device.

17. The method according to any of the preceding claims, wherein a plurality of data structures corresponding to images (I) is encoded, the components of the pixels (Px) of an image (I) among said plurality of images corresponding to the setpoint parameter values (PAR) intended for at least one actuator (12) among a plurality of actuators, the method further comprising:
- a step of comparing the images (I) belonging to the plurality of images (I) based on the evaluation of at least one similarity criterion (CrS); and
- a step of distributing the images (I) and/or the actuators (12) by groups (Gr) as a function of the evaluation of the at least one similarity criterion (CrS).

18. The method according to any of claims 1 to 5 or 11 to 17 provided that they depend on claims 2 to 4 whose steps are implemented by a computer (20) distinct from the at least one actuator (12).

19. The computer (20) comprising calculation means (21) arranged to implement the steps of a method according to any of claims 1 to 5 or 11 to 17 provided that they depend on claims 1 to 5.

20. An actuator (12) or assembly comprising an actuator (12) and a controller (11, 14) associated to the actuator (12) arranged to implement the steps of a method according to any of claims 6 to 10 or 11 to 17 provided that they depend on claims 6 to 10.

21. A system comprising at least one actuator (12) or an assembly according to claim 20 and at least one computer (20) according to claim 19.

22. A method for monitoring a building automation installation comprising at least one actuator, said method including:
- a step (S10) of determining a set (E1) of at least one combination (CVE1) of values (VE1) of quantities measurable by at least one sensor (13) associated to the actuator (12), called set of functional data (E1);
- a step (S30) of generating a reference data structure (DR) comprising determined values (VPi) of at least one setpoint parameter (PAR) implemented by a computer (20),
- a step of transferring said reference data structure (DR) from the computer (20) to the at least one actuator (12), and
- a step (E30) of controlling the at least one actuator (12) by applying a setpoint (Cs) determined as a function of the values of the at least one setpoint parameter (PAR) selected in the reference data structure (DR), implemented by the at least one actuator (12) or a controller (11, 14) associated to an actuator (12),
**characterized in that** the generation step (S30) comprises a sub-step (S35) of digitally encoding the reference data structure (DR) in the form of an image (I) comprising a set of pixels (Px), each pixel (Px) of the image being defined by a positioning and at least one component,
- the positioning (Pos) of a pixel (Px) in the image (I) being determined as a function (f) of the values (VE1) of the measurable quantities in said different combinations (CVE1) of the set of functional data (E1), and
- the at least one component of a pixel (Px) of the at least one image (I) corresponding to the setpoint parameter values (PAR) for a determined combination (CVE1) of values (VE1) of the measurable quantities of the set of functional data (E1).

23. The method according to claim 22, wherein the selection of at least one setpoint parameter (PAR) in the reference data structure (DR) is carried out as a function of a combination (CVE1j) of measured values (VE1) of quantities measurable by sensors (13) associated to the at least one actuator (12).

24. The method according to any of claims 22 or 23, wherein the computer (20) implements a step (S20) of determining at least one value (VPi) corresponding to the at least one setpoint parameter (PAR), for at least one determined combination (CVE1j) of values (VE1) of quantities measurable by at least one sensor (13) associated to the actuator (12).
